(19)

**Europäisches Patentamt**
**European Patent Office**
**Office européen des brevets**

(11) **EP 4 742 327 A1**

(12) **EUROPEAN PATENT APPLICATION**
published in accordance with Art. 153(4) EPC

(43) Date of publication:
**13.05.2026 Bulletin 2026/20**

(21) Application number: **24839399.3**

(22) Date of filing: **13.06.2024**

(51) International Patent Classification (IPC):
$H01M\ 4/62\ ^{(2006.01)}$    $C01B\ 32/16\ ^{(2017.01)}$
$C01B\ 32/168\ ^{(2017.01)}$    $G03F\ 1/62\ ^{(2012.01)}$
$H01B\ 1/04\ ^{(2006.01)}$    $H01M\ 4/13\ ^{(2010.01)}$
$H01M\ 4/139\ ^{(2010.01)}$    $H05K\ 9/00\ ^{(2006.01)}$

(52) Cooperative Patent Classification (CPC):
Y02E 60/10

(86) International application number:
**PCT/JP2024/021494**

(87) International publication number:
**WO 2025/013503 (16.01.2025 Gazette 2025/03)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.07.2023 JP 2023112657**
          **29.03.2024 JP 2024058117**

(71) Applicant: **Sumitomo Chemical Company, Limited**
**Tokyo 103-6020 (JP)**

(72) Inventors:
• YASHIRO, Arihiro
  Tsukuba-shi, Ibaraki 300-3294 (JP)
• ARIMURA, Takashi
  Tsukuba-shi, Ibaraki 300-3294 (JP)
• KAMEI, Ko
  Tsukuba-shi, Ibaraki 300-3294 (JP)
• AKATSU, Mitsutoshi
  Tsukuba-shi, Ibaraki 300-3294 (JP)

(74) Representative: **J A Kemp LLP**
**80 Turnmill Street**
**London EC1M 5QU (GB)**

(54) **CONDUCTIVE AUXILIARY AGENT, DISPERSION LIQUID, ELECTRODE, SECONDARY BATTERY, MULTI-WALLED CARBON NANOTUBE POWDER, PLANAR AGGREGATE, FILTER, ELECTROMAGNETIC SHIELD, AND PELLICLE FOR EXTREME ULTRAVIOLET RAYS**

(57)     To provide a conductive auxiliary agent, a dispersion liquid, an electrode, a secondary battery, as well as a multi-walled carbon nanotube powder, a planar assembly, a filter, an electromagnetic wave shielding and a pellicle for extreme ultraviolet rays, in which the enhancement effect of conductivity is excellent.

A conductive auxiliary agent, a dispersion liquid, an electrode, a secondary battery, as well as a multi-walled carbon nanotube powder, a planar assembly, a filter, an electromagnetic wave shielding and a pellicle for extreme ultraviolet rays, each including a multi-walled carbon nanotube powder that is a ground product of a multi-walled carbon nanotube having a tensile strength of 10 MPa to 100 MPa and that has an angle of repose of 10 degrees to 90 degrees.

EP 4 742 327 A1

## Description

Technical Field

The present disclosure relates to a conductive auxiliary agent, a dispersion liquid, an electrode, a secondary battery, a multi-walled carbon nanotube powder, a planar assembly, a filter, an electromagnetic wave shielding, and a pellicle for extreme ultraviolet rays.

Background Art

Carbon nanotubes (hereinafter, sometimes referred to as "CNTs") are favorable in mechanical properties and electric properties, and therefore are expected to be used in various applications. For example, Patent Literature 1 focuses on conductivity and adhesiveness of an electrode film included in a non-aqueous electrolyte secondary battery (in particular, lithium ion secondary battery), and proposes use of a carbon nanotube satisfying predetermined physical properties (namely, average outer diameter, BET specific surface area, fiber length, ratio of G/D, volume resistivity, and true density) in predetermined ranges.

Secondary batteries such as lithium ion secondary batteries are utilized for power sources in various fields of mobile devices, electric vehicles, and the like. It is known that conductive auxiliary agents, for example, carbonaceous materials such as carbon black, Ketjen black, fullerene, graphene, and CNT, and metal materials are used for electrode materials included in secondary batteries.

Citation List

Patent Literature

Patent Literature 1: Japanese Patent Laid-Open No. 2021-95314

Summary of Invention

Problems to be Solved by Invention

Carbonaceous materials such as carbon nanotubes have been conventionally known to be used as conductive auxiliary agents in order to enhance the conductivities in electrodes. However, electrodes with conventional conductive auxiliary agents have not sometimes achieved sufficient conductivities.

An object to be achieved by one embodiment of the present disclosure is to provide a conductive auxiliary agent excellent in the enhancement effect of conductivity.

An object to be achieved by another embodiment of the present disclosure is to provide a dispersion liquid, an electrode and a secondary battery, as well as a multi-walled carbon nanotube powder.

An object to be achieved by still another embodiment of the present disclosure is to provide a planar assembly including a multi-walled carbon nanotube powder, as well as a filter, an electromagnetic wave shielding and a pellicle for extreme ultraviolet rays, each including the planar assembly.

Means to Solve the Problems

The present disclosure includes the following aspects.

<1> A conductive auxiliary agent comprising a multi-walled carbon nanotube powder that is a ground product of a multi-walled carbon nanotube having a tensile strength of 10 MPa to 100 MPa and that has an angle of repose of 10 degrees to 90 degrees.

<2> The conductive auxiliary agent according to <1>, wherein the multi-walled carbon nanotube has a maximum length of 10 $\mu$m to 30000 $\mu$m.

<3> The conductive auxiliary agent according to <1> or <2>, which is a conductive auxiliary agent for a negative electrode.

<4> A dispersion liquid comprising the conductive auxiliary agent according to any one of <1> to <3> and a dispersion medium.

<5> An electrode comprising an electrode active material and the conductive auxiliary agent according to any one of <1> to <3>.

<6> A secondary battery comprising the electrode according to <5>.

<7> A multi-walled carbon nanotube powder that is a ground product of a multi-walled carbon nanotube having a tensile strength of 10 MPa to 100 MPa and a maximum length of 1000 $\mu$m to 30000 $\mu$m and that has an angle of repose of 10 degrees to 90 degrees.

<8> The multi-walled carbon nanotube powder according to <7>, which is a conductive auxiliary agent for a negative electrode.

<9> A dispersion liquid comprising the multi-walled carbon nanotube powder according to <7> or <8> and a dispersion medium.

<10> A composition comprising the multi-walled carbon nanotube powder according to <7> or <8> and at least one selected from the group consisting of a resin, ceramics and concrete.

<11> An electrode comprising an electrode active material and the multi-walled carbon nanotube powder according to <7> or <8>.

<12> A secondary battery comprising the electrode according to <11>.

<13> A dispersion liquid comprising a multi-walled carbon nanotube having a tensile strength of 10 MPa to 100 MPa and a maximum length of 1000 $\mu$m to 30000 $\mu$m, and a dispersion medium.

<14> A planar assembly comprising the multi-walled carbon nanotube powder according to <7>.

<15> A filter comprising the planar assembly according to <14>.

<16> An electromagnetic wave shielding comprising the planar assembly according to <14>.

<17> A pellicle for extreme ultraviolet rays comprising the planar assembly according to <14>.

Effects of Invention

According to one embodiment of the present disclosure, it is possible to provide a conductive auxiliary agent excellent in the enhancement effect of conductivity.

According to another embodiment of the present disclosure, it is possible to provide a dispersion liquid, an electrode and a secondary battery, as well as a multi-walled carbon nanotube powder.

According to still another embodiment of the present disclosure, it is possible to provide a planar assembly including a multi-walled carbon nanotube powder, as well as a filter, an electromagnetic wave shielding and a pellicle for extreme ultraviolet rays, each including the planar assembly.

Brief Description of Drawing

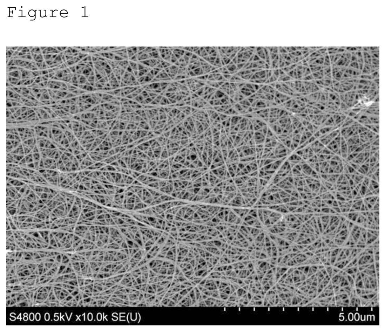

[Figure 1] Figure 1 is a scanning electron micrograph illustrating one aspect of a multi-walled carbon nanotube assembly.

Embodiments for Carrying out Invention

Hereinafter, one example of embodiments according to the present disclosure is described in detail. The following description may be made based on a representative embodiment of the present disclosure, but the present disclosure is not limited to such an embodiment and can be appropriately modified and then carried out within the objects of the present disclosure.

A numerical value range indicated with "to" in the present disclosure means a range including respective numerical values designated before and after "to" as the minimum value and the maximum value.

The upper limit value or the lower limit value in a certain numerical value range as a numerical value range designated stepwise in the present disclosure may be replaced with the upper limit value or the lower limit value of another numerical value range designated stepwise. The upper limit value or the lower limit value in a certain numerical value range as a numerical value range designated in the present disclosure may also be replaced with any value indicated in Examples.

A combination of two or more preferred aspects is a more preferred aspect in the present disclosure.

The amount of each component in the present disclosure means the total amount of plural substances in a case where such plural substances are present as those corresponding to such each component, unless particularly noted.

Herein, the term "step" encompasses not only an independent step, but also any step which can achieve the predetermined object even if such any step cannot be clearly distinguished from other steps.

[Conductive auxiliary agent]

The conductive auxiliary agent according to the present disclosure is a ground product of a multi-walled carbon nanotube having a tensile strength of 10 MPa to 100 MPa, and includes a multi-walled carbon nanotube powder having an angle of repose of 10 degrees to 90 degrees.

In the present disclosure, the conductive auxiliary agent refers to a substance which co-exists with an electrode active material (specifically, positive electrode active material or negative electrode active material) in an electrode formed with an electrode material to serve to play a role in assisting in conductivity and form a conductive path.

The conductive auxiliary agent according to the present disclosure is excellent in the enhancement effect of conductivity. In other words, the conductive auxiliary agent according to the present disclosure co-exists with an electrode active material in an electrode, thereby exerting an excellent effect on formability of a conductive path. Although the reason for this is not clear, it is presumed that, since the multi-walled carbon nanotube powder included in the conductive auxiliary agent according to the present disclosure is a ground product of a multi-walled carbon nanotube having a tensile strength in a specified range and has an angle of repose in the above range, such multi-walled carbon nanotubes or the multi-walled carbon nanotube and any material (for example, electrode active material and any other conductive substance) co-existing with the multi-walled carbon nanotube in an electrode are easily retained in the state of being mutually contacted, thereby forming a stable conductive path in such an electrode in synergy with excellent conductivity of the multi-walled carbon nanotube powder itself.

Although carbon nanotubes tend to be hardly dispersed in dispersion media (for example, water), a multi-walled carbon nanotube powder which is a ground product of a multi-walled carbon nanotube having a tensile strength in a specified range and which has an angle of repose in the above range is excellent in dispersibility in a dispersion medium in one aspect thereof. Therefore, it is presumed that, when such a multi-walled carbon nanotube powder is dispersed in a dispersion medium in formation of an electrode, such a multi-walled carbon nanotube powder is enhanced in dispersibility and thus contributes to formation of a stable conductive path in an electrode.

In the present disclosure, the "tensile strength" is measured with reference to the tensile test described in the standard of ISO 527-1.

The tensile strength of the multi-walled carbon nanotube according to the present disclosure (namely, the tensile strength of the multi-walled carbon nanotube before grinding into a multi-walled carbon nanotube powder) is to be measured in a state of a sheet, a thread, or the like which can be pulled.

The multi-walled carbon nanotube which is in the state of a sheet in the present disclosure means that a multi-walled carbon nanotube assembly before grinding into a multi-walled carbon nanotube powder has a sheet-like form.

The multi-walled carbon nanotube which is in the state of a thread in the present disclosure means that a multi-walled carbon nanotube assembly before grinding into a multi-walled carbon nanotube powder has a fibrous form.

The tensile strength is measured by the following specific measurement method and measurement conditions.

In a case where the multi-walled carbon nanotube before grinding is in a sheet-like form, the tensile strength is determined as the rupture strength at rupture of a measurement sample obtained by cutting out a sheet-like multi-walled carbon nanotube assembly to a size of 75 mm × 10 mm and fixed to a grasping portion of a tensile tester (Autograph AGS-X series manufactured by Shimadzu Corporation), in a tensile test performed at a rate of 1 mm/minute.

In a case where the multi-walled carbon nanotube before grinding is in a thread-like form, the tensile strength is determined as the rupture strength at rupture of a measurement sample obtained by cutting out a fibrous multi-walled carbon nanotube to a length of 500 mm and fixed to a grasping portion of a tensile tester (Autograph AGS-X series manufactured by Shimadzu Corporation), in a tensile test performed at a rate of 1 mm/minute with a thin-line gripping tool (manufactured by Shimadzu Corporation).

In a case where such a measurement sample in a sheet-like form does not satisfy the above size or such a measurement sample in a thread-like form does not satisfy the above length, such a measurement sample is directly used to measure the tensile strength.

The tensile strength of the multi-walled carbon nanotube is 10 MPa to 100 MPa, preferably 30 MPa to 85 MPa, more preferably 50 MPa to 70 MPa. When the tensile strength of the multi-walled carbon nanotube is 50 MPa or more, the length of the multi-walled carbon nanotube is sufficiently long and thus the conductivity of the multi-walled carbon nanotube is easily ensured. When the tensile strength of the multi-walled carbon nanotube is 70 MPa or less, the force necessary for grinding and processing such a sheet-like or thread-like multi-walled carbon nanotube is small and thus easy processing can be made.

As the method for grinding and processing such a multi-walled carbon nanotube having a tensile strength of 10 MPa to 100 MPa, for example, a freeze-grinding method can be used. The freeze-grinding method is a processing method including rapidly cooling an assembly of the multi-walled carbon nanotube with liquid nitrogen to allow the multi-walled carbon nanotube to be lost in elasticity, thereby facilitating grinding even in each case where the assembly of the multi-walled carbon nanotube is in a sheet-like or thread-like form. Alternatively, grinding by a known method with a ball mill or the like may also be carried out.

In the present disclosure, the "angle of repose" refers to an angle which, when a mountain of a powder, deposited by dropping the powder from a certain height onto a horizontal surface, is stably kept without spontaneously breaking, is formed between a slope of the mountain of the powder and the horizontal surface.

In the present disclosure, the angle of repose is measured by an injection method. The injection method is a method including depositing a powder as a measurement object on a measurement stage having a disc-like upper surface to measure the angle of repose. The injection method is hardly affected by the material of the measurement stage, and the angle (namely, angle of repose) between the powder deposited in a conical manner and the horizontal surface can be easily measured with a measurement tool such as a protractor. The angle of repose can also be measured with a commercially available measurement machine. Examples of the commercially available measurement machine include an angle of repose tester AOR-57 Model (manufactured by Tsutsui Scientific Instruments Co., Ltd.).

The angle of repose can be adjusted by the shape (size, end shape, or the like), the particle size, or the like of the multi-walled carbon nanotube.

The angle of repose of the multi-walled carbon nanotube powder in the conductive auxiliary agent according to the present disclosure is 10 degrees to 90 degrees (namely, 10 degrees or more and 90 degrees or less), and in a certain aspect, the angle of repose is preferably 10 degrees or more and less than 40 degrees, more preferably 20 degrees or more and less than 40 degrees, further preferably 36 degrees or more and less than 40 degrees.

The angle of repose is preferably 10 degrees or more and less than 70 degrees, more preferably 10 degrees or more and less than 50 degrees, particularly preferably 10 degrees or more and less than 34 degrees from the viewpoint of allowing the multi-walled carbon nanotube powder to ensure fluidity and thus be favorably handled during production and from the viewpoint of improving dispersibility in an aqueous solvent.

In this regard, the angle of repose is preferably 20 degrees or more and less than 90 degrees, more preferably 30 degrees or more and less than 85 degrees, particularly preferably 36 degrees or more and less than 80 degrees from the viewpoint of increasing the friction force between such multi-walled carbon nanotube powders to allow for easy formation of a conductive path.

The bulk density of the multi-walled carbon nanotube powder in the conductive auxiliary agent according to the present disclosure is preferably $0.001 \, \text{g/cm}^3$ to $0.19 \, \text{g/cm}^3$, more preferably $0.002 \, \text{g/cm}^3$ to $0.1 \, \text{g/cm}^3$, further preferably $0.005 \, \text{g/cm}^3$ to $0.08 \, \text{g/cm}^3$ from the viewpoint of improving dispersibility in an aqueous solvent.

In this regard, the bulk density is preferably $0.001 \, \text{g/cm}^3$ or more, more preferably $0.002 \, \text{g/cm}^3$ or more, further preferably $0.005 \, \text{g/cm}^3$ or more from the viewpoint of allowing for easy introduction into an aqueous solvent and from the viewpoint of allowing for easy securement of operation ability.

The bulk density of the multi-walled carbon nanotube powder is measured in terms of a tapped bulk density.

The tapped bulk density refers to a measurement value of the bulk density measured after a measurement container filled with the multi-walled carbon nanotube powder is dropped onto a hard surface from a height of 25 mm repeatedly 20 times.

The multi-walled carbon nanotube powder in the conductive auxiliary agent according to the present disclosure mainly contains carbon and thus is favorable in conductivity.

In the present disclosure, the conductivity of the multi-walled carbon nanotube powder can be measured in terms of volume resistivity.

In the present disclosure, when the volume resistivity of the multi-walled carbon nanotube powder pressed in a condition of 20 kN is $5.0 \times 10^{-2} \, \Omega \cdot \text{cm}$ or less, the multi-walled carbon nanotube powder can be determined to be excellent in conductivity.

The volume resistivity of the multi-walled carbon nanotube powder in a pressing condition of 20 kN is preferably $5.0 \times 10^{-2} \, \Omega \cdot \text{cm}$ or less, more preferably $1.0 \times 10^{-4} \, \Omega \cdot \text{cm}$ to $3.0 \times 10^{-2} \, \Omega \cdot \text{cm}$, further preferably $1.0 \times 10^{-4} \, \Omega \cdot \text{cm}$ to $2.0 \times 10^{-2} \, \Omega \cdot \text{cm}$, particularly preferably $1.0 \times 10^{-4} \, \Omega \cdot \text{cm}$ to $2.0 \times 10^{-3} \, \Omega \cdot \text{cm}$.

The volume resistivity of the multi-walled carbon nanotube powder is measured by a four probe method at 25°C with a resistivity meter. The resistivity meter used here can be a Loresta apparatus.

Specifically, the volume resistivity ($\Omega \cdot \text{cm}$) is measured with a Loresta apparatus (product names: powder resistance measurement system MCP-PD51, low-resistivity meter Loresta-GP, and low-resistance probe for powders, MCP-PD511 (constant-current application-type four probe method), all manufactured by Nittoseiko Analytech Co., Ltd.) after the multi-walled carbon nanotube powder is introduced into a resistivity measurement probe unit and pressed at 20 kN with an attached hydraulic pump to allow a target load to be achieved.

The conductive auxiliary agent according to the present disclosure is not particularly restricted as long as it includes a multi-walled carbon nanotube powder that is a ground product of a multi-walled carbon nanotube having a tensile strength of 10 MPa to 100 MPa and that has an angle of repose of 10 degrees to 90 degrees, and the multi-walled carbon nanotube powder is preferably a ground product of a multi-walled carbon nanotube having a tensile strength of 10 MPa to 100 MPa and a maximum length of 10 $\mu$m to 30000 $\mu$m from the viewpoint of imparting excellent conductivity.

The grinding treatment for obtaining the ground product of the multi-walled carbon nanotube is not particularly restricted, and any grinding treatment capable of crushing the multi-walled carbon nanotube into a small piece may be used.

The grinding treatment may be a treatment for grinding the multi-walled carbon nanotube in the state of being frozen. A grinding apparatus (for example, ball mill) is preferably used in the grinding treatment. The grinding apparatus can be appropriately selected depending on the amount of the multi-walled carbon nanotube to be subjected to grinding. The grinding apparatus used here can be, for example, a ball mill "JFC-300" manufactured by Japan Analytical Industry.

The multi-walled carbon nanotube to be subjected to the grinding treatment may be an assembly of the multi-walled carbon nanotube. The shape of the multi-walled carbon nanotube to be subjected to the grinding treatment may be, for example, a sheet-like (also referred to as "mat-like") or thread-like shape, and sheet-like one is preferred because of being not too hard and being able to be treated in a large amount at one time.

One aspect of the present disclosure includes a multi-walled carbon nanotube powder that is a ground product of a multi-walled carbon nanotube having a tensile strength of 10 MPa to 100 MPa and a maximum length of 1000 $\mu$m to 30000 $\mu$m and that has an angle of repose of 10 degrees to 90 degrees (hereinafter, also referred to as "multi-walled CNT powder A"). In other words, the conductive auxiliary agent according to the present disclosure can include the multi-walled CNT powder A.

The multi-walled CNT powder A can be not only applied as the conductive auxiliary agent, but also used in various applications such as conductive ink, a filler for resin reinforcement, an antistatic agent, and a transparent conductive film material, and the scope of application thereof is wide.

Another aspect of the present disclosure includes a multi-walled carbon nanotube powder that is a ground product of a multi-walled carbon nanotube including a multi-walled carbon nanotube having a maximum length of 1000 $\mu$m to 30000 $\mu$m and that has a particle size distribution value (Dcnt) of 0.5 to 10, as represented by the following expression (1), (hereinafter, also referred to as "multi-walled CNT powder B").

$$\text{Particle size distribution value (Dcnt)} = [Dn90 - Dn10]/Dn50 \qquad \text{Expression (1)}$$

In the expression (1), Dn90 is a number average particle size measured on a 90% basis, Dn10 is a number average particle size measured on a 10% basis, and Dn50 is a number average particle size measured on a 50% basis, by observation of the ground product of the multi-walled carbon nanotube placed in distilled water and left to stand for 3 hours, with an optical microscope.

The particle size distribution value (Dcnt) of the multi-walled CNT powder B is 0.5 to 10, preferably 1.1 to 10, more preferably 2.0 to 10.

The ground product preferably simultaneously satisfies a particle size or an average particle size of 100 to 30000 $\mu$m and a strand diameter of 5 to 50000 nm.

The multi-walled CNT powder B is a ground product of a multi-walled carbon nanotube including a multi-walled carbon nanotube having a maximum length of 1000 $\mu$m to 30000 $\mu$m and has a particle size distribution value (Dcnt) of 0.5 to 10, and thus is excellent in conductivity and also excellent in dispersibility in a dispersion medium (for example, water). Although carbon nanotubes tend to be hardly dispersed in dispersion media (for example, water), the multi-walled CNT powder B has a particle size distribution value (Dcnt) in the above range and thus is excellent in dispersibility in a dispersion medium. Therefore, the multi-walled CNT powder B can be suitably used as, for example, a conductive auxiliary agent. In other words, it is presumed that the multi-walled CNT powder B, when applied to a conductive auxiliary agent, contributes to formation of a stable conductive path in an electrode in synergy with an excellent conductivity of the powder itself.

The multi-walled CNT powder B can be not only applied as a conductive auxiliary agent, but also used in various applications such as conductive ink, a filler for resin reinforcement, an antistatic agent, and a transparent conductive film material, and the scope of application thereof is wide.

The multi-walled CNT powder B may have an angle of repose of 10 degrees to 90 degrees. In other words, the conductive auxiliary agent according to the present disclosure can include such a multi-walled CNT powder B which has an angle of repose of 10 degrees to 90 degrees.

<Multi-walled carbon nanotube>

The multi-walled carbon nanotube for obtaining the multi-walled carbon nanotube powder in the present disclosure includes a multi-walled carbon nanotube having a maximum length of 10 $\mu$m to 30000 $\mu$m (preferably, 1000 $\mu$m to 30000 $\mu$m).

The terms "carbon nanotube", "single-walled carbon nanotube", "multi-walled carbon nanotube", and "multi-walled CNT having a maximum length of 1000 $\mu$m to 30000 $\mu$m" in the description of "multi-walled carbon nanotube" and "method for producing the multi-walled carbon nanotube" described below in detail may be respectively abbreviated as "CNT", "SWCNT", "MWCNT", and "ULMWCNT".

ULMWCNT has a maximum length of 1000 $\mu$m to 30000 $\mu$m and can have a longer length than that of general-purpose MWCNT, and take a fiber shape.

The term "fiber" is generally used for referring to a structure where one dimension is larger than those of two other dimensions. The fiber may be a thread-like fiber whose transverse section is circular, may be a ribbon-like fiber whose transverse section is rectangular, may be hollow, or may have any other shape. The transverse section of ULMWCNT is preferably circular or preferably hollow from the viewpoint of increasing the conductivity.

ULMWCNT, which takes a fiber shape, thus has the property of being easily mutually entangled. MWCN includes at least one ULMWCNT and is preferably an assembly including plural ULMWCNTs because MWCNTs are mutually entangled to easily form a more stable assembly. Hereinafter, an assembly including ULMWCNT may be abbreviated as "ULMWCNT assembly".

An assembly of MWCNT may be an assembly of a three-dimensional structure by mutual entanglement.

Figure 1 is a scanning electron microscope (SEM) photograph illustrating one aspect of the assembly of MWCNT in the present disclosure. It can be seen from the SEM photograph illustrated in Figure 1 that plural fibrous ULMWCNTs are entangled to form an assembly. It can be thus confirmed by SEM observation that ULMWCNT in the present disclosure is in the state of being entangled.

The length of ULMWCNT can be measured by focusing on one ULMWCNT and observing plural SEM photographs at adjacent viewing angles. The "length of ULMWCNT" refers to a measured value of the length in the longitudinal direction of ULMWCNT, and the maximum value among such length values measured is defined as "maximum length".

In a case where SEM photograph observation shows one MWCNT having a maximum length in a range of 1000 $\mu$m to 30000 $\mu$m observed within the viewing angle in such a SEM photograph, it can be confirmed that ULWMCNT is included in MWCNTs observed.

Plural ULMWCNTs are preferably present in the viewing angle in such a SEM photograph. In a case where 100 of such MWCNTs included in the viewing angle in such a SEM photograph are focused on and the respective maximum lengths are measured, MWCNT having a maximum length in a range of 1000 $\mu$m to 30000 $\mu$m (namely, ULMWCNT), among MWCNTs observed, is preferably present at 10% or more, more preferably present at 20% or more, further preferably present at 30% or more, particularly present at 50% or more in terms of number, from the viewpoint of a more enhancement in stability of the assembly of MWCNT due to mutual entanglement of ULMWCNT.

The diameter of ULMWCNT can be measured by observing a SEM photograph or a transmission electron microscope (TEM) photograph. The diameter here refers to a length in a direction perpendicular to the longitudinal direction of ULMWCNT, and the diameters at different 10 points of one ULMWCNT are measured and the average value thereof is defined as the diameter of ULMWCNT.

The length of ULMWCNT is in a range of 1000 $\mu$m to 30000 $\mu$m, preferably in a range of 1050 $\mu$m to 25000 $\mu$m, more preferably in a range of 1100 $\mu$m to 20000 $\mu$m, further preferably in a range of 1200 $\mu$m to 18000 $\mu$m, particularly preferably in a range of 1300 $\mu$m to 15000 $\mu$m. The diameter of ULMWCNT is preferably 1 nm to 100 nm, more preferably 2 nm to 80 nm, further preferably 3 nm to 50 nm, particularly preferably 5 nm to 30 nm.

The length/diameter ratio of ULMWCNT, so-called aspect ratio, is preferably 1000 or more, more preferably 3000 or more, further preferably 5000 or more, particularly preferably 10000 or more.

The aspect ratio can be calculated from the ratio of the maximum length and the diameter of one ULMWCNT. The average value of the measured values of 20 or more ULMWCNTs is preferably adopted from the viewpoint of measurement accuracy.

The specific gravity of the ULMWCNT assembly is preferably in a range of 1.5 to 2.5, more preferably in a range of 1.7 to 2.4, further preferably in a range of 1.8 to 2.2 from the viewpoint of dispersibility.

The specific gravity of the ULMWCNT assembly can be measured by a method described in JIS Z8807:2012 "Methods of measuring density and specific gravity of solid".

The purity of MWCNT in the ULMWCNT assembly can be measured by thermogravimetric analysis. For example, a thermal analysis apparatus (manufactured by Shimadzu Corporation, DTG-60) is used to obtain a thermogravimetric (TG) curve and a differential thermal analysis (DTA) curve of the ULMWCNT assembly. The largest exothermic peak in the DTA curve, in which the peak top appears around 650°C to 750°C, is determined to indicate burning of MWCNT and any other exothermic peak than the above peak in the curve is determined to indicate burning of any other substance than MWCNT. The purity of MWCNT is determined from the rate of weight reduction in the TG curve. The purity of the ULMWCNT assembly is preferably 50% by mass or more, more preferably 65% by mass or more, further preferably 80% by mass or more, particularly preferably 95% by mass or more from the viewpoint of the conductivity obtained.

ULMWCNT may contain 0.01% by mass to 50% by mass of a Fe atom derived from iron being a catalyst used in production. ULMWCNT may contain a Fe atom, for example, in a state where the atom adsorbs to a surface of ULMWCNT or in a state where the atom is incorporated in fibrous ULMWCNT formed in production.

The resulting fibrous ULMWCNT is preferably flexible and strong.

The conductivity of ULMWCNT itself is preferably 5000 $\Omega^{-1} \cdot m^{-1}$ or more, more preferably 10000 $^{-1} \cdot m^{-1}$ or more. The conductivity of ULMWCNT itself is here usually 1000000 $\Omega^{-1} \cdot m^{-1}$ or less.

<Method for producing multi-walled carbon nanotube>

The method for producing MWCNT (namely, ULMWCNT-containing MWCNT) in the present disclosure is not particularly limited.

The method for producing MWCNT in the present disclosure, applied here, is a method such as a conventionally known chemical vapor deposition (CVD) method or a method including reacting a gaseous reactant containing a carbon source in the presence of a catalyst.

MWCNT in the present disclosure can be produced with reference to, for example, a production method described in Japanese Patent Laid-Open No. 2016-102047.

Hereinafter, the method for producing MWCNT in the present disclosure is described with reference to one example. It is noted that the method for producing MWCNT in the present disclosure is not limited to the following example.

One example of the method for producing MWCNT in the present disclosure is, for example, a production method described in Japanese Patent Laid-Open No. 2016-102047, namely, a production method including a step of allowing a gaseous reactant containing one or plural carbon sources to pass through a reactor, a step of reacting one or plural gaseous reactants in the presence of a catalyst in a reaction region of the reactor, to form a product particle containing carbon, a step of aggregating the product particle into an agglomerate, and a step of applying force to the agglomerate to continuously move the agglomerate outside the reaction region (hereinafter, also referred to as "production method X").

According to the production method X, ULMWCNT-containing MWCNT, which is easily handled, can be obtained in the form of a fibrous agglomerate form or in the form of any other agglomerate form.

The force applied to the product particle in the production method X may be mechanical force.

In a case where the agglomerate is fibrous MWCNT, the mechanical force applied to the product particle can be applied with a rotatable spindle around which the agglomerate is to be wound. This fibrous CNT may be recovered on the spindle, or may be accumulated on any other location by rotation around the spindle once or plural times and then continuous rewinding of the spindle.

The spindle is preferably disposed so that the spindle shaft is placed perpendicular to or in parallel with the flowing direction of the one or plural gaseous reactants, or may be placed in any other orientation. For example, a spindle in which the spindle shaft is placed at an angle of 25° to the flowing direction of the gaseous reactant(s) can also be suitably used for applying mechanical force to the product particle.

The spindle can rotate around two axes (for example, two perpendicular axes). In particular, the spindle can rotate around the respective axes perpendicular to and in parallel with the flowing direction of the gaseous reactant(s). According to such a spindle, the number of twists and the length can be controlled to pull and/or twist the agglomerate being fibrous CNT.

The material of the spindle may be made of a metal, ceramic, or a resin.

The spindle can take a different suitable shape depending on properties of the material and the intended use of MWCNT. The spindle can be used, for example, as a template for producing a carbon product by a spin-coating production method. A preferred shape of the spindle is a rod shape or a box shape.

The fibrous MWCNT is accumulated on the spindle or any other location, and the coating thickness and the orientation can be controlled by control of the reaction time and reaction conditions or by conditions of application of the electric field or any other field to the carbon product. The coating thickness and the orientation of the carbon product can be controlled by, for example, the flowing force of gas.

The rotational rate of the spindle is preferably 0.01 rpm (rotations/minute; the same also applies to the following) to 10000 rpm, more preferably 0.1 rpm to 100 rpm.

The spinning rate (namely, the rotational rate of the spindle) may be adjusted so that a substance is recovered at the same rate as the rate of production thereof. The thickness of the fibrous MWCNT accumulated may also be controlled by the rotational rate of the spindle. In one preferred embodiment, when the spindle is rotated, the fibrous CNT is processed in the shaft direction of the spindle. The above processing allows the fibrous MWCNT not to be wound only on one specified location on the spindle, but to be evenly wound along with the spindle.

The fibrous MWCNT may be recovered on the wall of the reactor, for example, with a substrate put in the reactor. The substrate may be a substrate fixed, or may be a rotation guide used for applying strong and even force to the fibrous MWCNT in the case of recovery of the fibrous MWCNT. Examples of an appropriate aspect of placement of the substrate, to be used for fiber techniques, include a substrate including two guides placed at positions perpendicular to each other.

The mechanical force applied to the product particle in the production method X may be force applied with an accelerated gas flow. The accelerated gas flow can be generated by allowing the product particle to pass through a reactor having a narrow diameter or pass through a capillary tube located downstream of the reaction region. Vacuum may also be applied to the product particle.

Examples of any other force applied to the product particle include electrostatic force appropriately applied with a charged plate. In the case of use of such electrostatic force, the product particle is required to be charged. The charged plate can be used to produce MWCNT in a mat form in which such MWCNTs are mutually entangled on the charged plate.

Such any other force applied to the product particle may be magnetic force, or may be photon pressure applied with a light source.

The raw material of CNT may be injected in a liquid form containing a carbon source instead of a gaseous reactant containing a carbon source. Such a liquid, when used as the raw material of CNT, can be injected through a single injection port or multiple injection ports, and can be injected, for example, with the placement of a showerhead.

The one or plural gaseous reactants are preferably reacted at 500°C to 1600°C, more preferably reacted at 1000°C to 1500°C or 1600°C (in particular, 1000°C to 1500°C). Preferably, the temperature gradient is retained in the reactor and the reaction region is kept at a temperature higher than that of a product region of the reactor.

The gaseous reactant(s) may be mixed with one or plural gases acting as a diluent. The gaseous reactant(s) may also be mixed with a gas which does not play a direct role in the reaction, but is of some help. In a case where amorphous carbon as a by-product is produced, a gas which can react with such amorphous carbon to normally keep a reaction moiety on a catalyst and thus produce a nanotube is also preferably used as a diluent.

Examples of the gas usable as the diluent include argon or other inert gases, hydrogen, nitrogen, ammonia, carbon dioxide, and helium. In particular, the gas usable as the diluent is particularly preferably hydrogen. The flow rate of the gas as the diluent is preferably 2000 mL (milliliters)/minute or less, more preferably 400 mL/minute to 800 mL/minute.

The gas pressure of the gaseous reactant(s) and any diluent is preferably 0.1 bar to 50 bar, more preferably 0.5 bar to 5 bar, further preferably 1 bar to 2 bar. In a case where any gas flows out from a furnace, the gas flowing out can be recycled with or without cleaning.

The compositional ratio and the like of the product particle can be controlled by monitoring the agglomerate and modifying reaction conditions based on the resulting information. For example, the agglomerate can be monitored by online Raman spectroscopy. According to online Raman spectroscopy, the data is obtained which indicates whether the agglomerate is single-walled CNT or multi-walled CNT. The data is also obtained which indicates the diameter and the crystallinity of the CNT. The agglomerate can also be monitored by online conductometry, gas analysis, measurement of the opacity of the reaction region and/or measurement of winding force.

When the agglomerate is taken out from the reactor, air is preferably prevented from penetrating in the reactor. In a case where the gas as the diluent contains hydrogen, it is particularly important, for example, from the viewpoint of preventing an explosive mixture of hydrogen and air from being formed in the reactor to prevent air from flowing in.

The product particle in the production method X includes ULMWCNT. Not only MWCNT, but also SWCNT may be included depending on production conditions.

The product particle may be produced by a chemical vapor deposition method. In a case where the product particle is produced by a chemical vapor deposition method, the carbon source corresponding to the gaseous reactant(s) is reacted in the presence of a catalyst.

Examples of an appropriate carbon-containing compound as the carbon source include carbon monoxide, carbon dioxide, aromatic hydrocarbon (for example: benzene, toluene, xylene, cumene, ethylbenzene, naphthalene or mesitylene), non-aromatic hydrocarbon (for example: methane, ethane, propane, butane, pentane, hexane, cyclohexane, ethylene, propylene or acetylene), and oxygen-containing hydrocarbon (for example: hydrocarbon containing formaldehyde, acetaldehyde, acetone, methanol, ethanol, diethyl ether, polyethylene glycol, 1-propanol, ethyl formate, or a mixture of two or more of these).

The carbon-containing compound is preferably carbon monoxide, methane, ethylene or acetylene.

The carbon source preferably contains oxygen. Ethanol is a particularly preferred carbon source.

Oxygen can be introduced into the reactor by other method, for example, a method with a dilution gas- or water-containing carbon source.

The gaseous reactant being the carbon source is preferably injected at a rate of 0.01 mL/minute to 10 mL/minute, more preferably at a rate of 0.08 mL/minute to 0.25 mL/minute into the reactor.

The catalyst is preferably any in the transition metal group, in particular, chromium (Cr), molybdenum (Mo), or tungsten (W) in the group VIB, or any in the VIIIB transition metal group. Specifically, the catalyst is preferably, for example, iron (Fe), cobalt (Co), nickel (Ni), ruthenium (Ru), rhodium (Rh), palladium (Pd), osmium (Os), iridium (Ir) and platinum (Pt) or manganese (Mn), or a mixture thereof. Any metal (for example, yttrium (Y)) from lanthanide and actinide columns can also be used as the catalyst. More preferred are Fe, Ni, Co, Mo and any mixture thereof, for example, a mixture of Ni and Co (mass ratio: 50/50), a mixture of Fe and Ni, or a mixture of Fe and Mo.

These transition metals can be each used singly or combined with any other transition metal listed, and can each function as a catalyst for growth of CNT. The catalyst is particularly preferably a mixture of two or more metals listed.

The catalyst is preferably formed by decomposition of a precursor. The precursor is preferably a heat-, light- or plasma-degradable compound of the above one or plural metals, for example, a carbonyl or cyclopentadienyl organometallic compound. The precursor is particularly preferably any of ferrocene, iron pentacarbonyl, nickelocene and cobaltocene. At least 0.01% by mass of the precursor is appropriately included in the carbon source, and 0.2% by mass to 2.5% by mass of the precursor is more preferably included in the carbon source. In a certain aspect, 0.23% by mass to 2.3% by mass of the precursor is included in the carbon source.

The catalyst may be supported on a carrier and thus used. Examples of a preferred carrier include silica and magnesium oxide.

The carbon source is preferably reacted in the presence of a promotor. An appropriate promotor is one or more of sulfur, phosphorus, molybdenum and an organic compound of such an element. One of preferred promotors is thiophene.

The carbon source appropriately includes up to 10% by mass (10% by mass or less) of such a promotor. The carbon source preferably includes 0.2% by mass to 6% by mass of such a promotor. In a case where thiophene at a high concentration or a low concentration is used as such a promotor, MWCNT is formed.

For example, MWCNT is favorably formed with ethanol containing 0% by mass or 1.5% by mass to 4.0% by mass of thiophene and 1.0% by mass to 10.0% by mass (in particular, 2.3% by mass) of ferrocene, according to conditions of a rate of injection of 5.0 mL/hour to 30.0 mL/hour (in particular, 7.5 mL/hour), a flow rate of hydrogen of 400 mL/minute to 800 mL/minute, and a synthesis temperature of 1100°C to 1180°C.

According to the production method X, fibrous CNT having a length of at least 500 μm, for example, at least 1 mm can be obtained. This fibrous CNT can take a thread-like or mat-like form.

The length of the fibrous CNT can be controlled by, for example, the winding ability of a spindle used for production of the fibrous CNT.

The production method X preferably includes a step of reacting the carbon source in the reaction region of the reactor to produce CNT and a step of applying force to the CNT to form the CNT into an agglomerate. According to this production method, fibrous CNT can be easily produced.

In another aspect, there may also be taken a procedure including producing ULMWCNT-containing MWCNT in the reaction region by the above method and then forming ULMWCNT-containing MWCNT by aggregation, and continuously withdrawing MWCNT from the vicinity of the reaction region.

In another aspect, there may also be taken a procedure including producing ULMWCNT-containing MWCNT in the reaction region, continuously electrostatically drawing the ULMWCNT-containing MWCNT, from the reaction region, and recovering the ULMWCNT-containing MWCNT.

The production method X is one example, and the method for producing ULMWCNT-containing MWCNT is not limited to the above.

The conductive auxiliary agent according to the present disclosure is preferably included in an electrode, preferably included in an electrode included in a secondary battery, preferably included in a negative electrode included in a secondary battery. In other words, the conductive auxiliary agent according to the present disclosure is preferably a conductive auxiliary agent for a negative electrode. An electrode and a secondary battery, to which the conductive auxiliary agent according to the present disclosure can be applied, are described later.

[Dispersion liquid]

The dispersion liquid according to the present disclosure includes the conductive auxiliary agent according to the present disclosure, and a dispersion medium.

The dispersion liquid according to the present disclosure is favorable in dispersibility in the dispersion medium in the conductive auxiliary agent according to the present disclosure, and is excellent in conductivity.

The dispersion liquid according to the present disclosure is preferably used for formation of an electrode.

<Conductive auxiliary agent>

The conductive auxiliary agent included in the dispersion liquid according to the present disclosure is the same as the above-mentioned conductive auxiliary agent according to the present disclosure, and therefore the description thereof is here omitted.

<Dispersion medium>

The dispersion medium preferably contains water, and more preferably contains water as a main component.

The "containing water as a main component" means that the proportion of water in the dispersion medium is more than 50% by mass. The proportion of water in the dispersion medium is preferably 90% by mass or more, more preferably 95% by mass or more, further preferably 99% by mass or more, and may be, for example, 100% by mass.

The water is not particularly limited, and is preferably, for example, distilled water, ion-exchange water, or pure water because impurities are less incorporated.

The dispersion medium may be a mixed liquid of water and a hydrophilic solvent.

Examples of the hydrophilic solvent include solvents, for example, carbonate compounds such as ethylene carbonate, propylene carbonate, dimethyl carbonate, diethyl carbonate, methyl ethyl carbonate, and butylene carbonate; ether compounds such as tetrahydrofuran; ketone compounds such as acetone; lower alcohol compounds such as methanol and ethanol; and acetonitrile.

In a case where the dispersion medium includes a hydrophilic solvent, the proportion of the hydrophilic solvent in the dispersion medium is preferably 10% by mass or less, more preferably 5% by mass or less, further preferably 1% by mass or less.

The dispersion liquid may further include any other component usable in the dispersion liquid, in addition to the conductive auxiliary agent according to the present disclosure and dispersion medium.

Examples of such any other component include a dispersant, a defoamer, an antistatic agent, and any other conductive auxiliary agent than the conductive auxiliary agent according to the present disclosure. A trace of an impurity component, so-called inevitable impurities or the like may be further included.

<Dispersant>

The dispersion liquid may include a dispersant for the purpose of further enhancing dispersibility and dispersion stability of the conductive auxiliary agent.

The dispersant is not particularly limited, and examples thereof include various surfactants. Examples of the dispersant also include a polymer compound such as a resin.

The dispersant is preferably a surfactant.

The surfactant may be an ionic surfactant or a non-ionic surfactant, and is not particularly limited.

The surfactant can be used singly or as a mixture of two or more kinds thereof.

Examples of the ionic surfactant include an anionic surfactant, a cationic surfactant and an ampholytic surfactant.

Examples of the anionic surfactant include an aromatic sulfonic acid-based surfactant such as alkylbenzenesulfonate (for example: dodecylbenzenesulfonic acid) or dodecyl phenyl ether sulfonate; an ether sulfate-based surfactant; a phosphate-based surfactant; and a carboxylic acid-based surfactant.

Examples of the cationic surfactant include an alkylamine salt and a quaternary ammonium salt.

Examples of the ampholytic surfactant include an alkyl betaine-based surfactant and an amine oxide-based surfactant.

The ionic surfactant is preferably an ionic surfactant having an aromatic ring (so-called, aromatic ionic surfactant), more preferably an aromatic sulfonic acid-based surfactant such as alkylbenzenesulfonate or dodecyl phenyl ether sulfonate.

The aromatic ionic surfactant tends to be excellent in dispersion ability, dispersion stabilization ability and increase in concentration of the multi-walled carbon nanotube.

Examples of the non-ionic surfactant include sugar ester-based surfactants such as sorbitan fatty acid ester and polyoxyethylene sorbitan fatty acid ester; fatty acid ester-based surfactants such as polyoxyethylene resin acid ester and polyoxyethylene fatty acid diethyl; ether-based surfactants such as polyoxyethylene alkyl ether, polyoxyethylene alkylphenyl ether, and polyoxyethylene·polypropylene glycol; and aromatic non-ionic surfactants such as polyoxyalkylene octyl phenyl ether, polyoxyalkylene nonyl phenyl ether, polyoxyalkyldibutyl phenyl ether, polyoxyalkylstyryl phenyl ether, polyoxyalkylbenzyl phenyl ether, polyoxyalkylbisphenyl ether, polyoxyalkylcumyl phenyl ether, and polyoxyalkylene phenyl ether.

The non-ionic surfactant is preferably an ionic surfactant having an aromatic ring (so-called, aromatic non-ionic surfactant), more preferably polyoxyalkylene phenyl ether, further preferably polyoxyethylene phenyl ether.

The aromatic non-ionic surfactant tends to be excellent in dispersion ability, dispersion stabilization ability and increase in concentration of the multi-walled carbon nanotube.

Examples of any other dispersant excellent in dispersion ability, dispersion stabilization ability and increase in concentration of the multi-walled carbon nanotube include sodium salts of β-naphthalenesulfonic acid formalin condensates, Demol N, Demol RN, and Demol T (manufactured by Kao Corporation), polyoxyethylene stearyl ether, Brij S 100 (manufactured by Sigma-Aldrich), polyvinylpyrrolidone K30 (for example, manufactured by FUJIFILM Wako Pure Chemical Corporation), carboxymethylcellulose (CMC) (for example, manufactured by Daicel Miraizu Ltd.), sodium deoxycholate (for example, manufactured by FUJIFILM Wako Pure Chemical Corporation), and SOLSPERSE(TM) W100 and SOLSPERSE(TM) W150 (manufactured by Lubrizol Japan Ltd.). CMC is particularly preferred from the viewpoint of being excellent in dispersion ability, dispersion stabilization ability and increase in concentration of the multi-walled carbon nanotube.

In a case where the dispersion liquid includes the dispersant, the amount of the dispersant used is not particularly limited, and can be appropriately set depending on the type of the dispersant, the amount of the multi-walled carbon nanotube, the amount of the dispersion medium, and the like.

[Method for producing dispersion liquid]

The method for producing the dispersion liquid is not particularly limited.

The dispersion liquid can be produced by dispersing the conductive auxiliary agent according to the present disclosure in the dispersion medium. In other words, the dispersion liquid according to the present disclosure can be produced by a method including a step of dispersing the conductive auxiliary agent according to the present disclosure in the dispersion medium (also referred to as "dispersion step").

The dispersion medium usable in the dispersion step is as described above.

The dispersion method is not particularly limited.

Examples of the dispersion method include a method with a dispersion apparatus such as a stirring machine, a homogenizer, a colloid mill, a flow jet mixer, a dissolver, a paint conditioner, a Manton emulsifying apparatus, a jet mill, or an ultrasonic apparatus.

Examples of the dispersion method also include a method with a known grinding tool, for example, a dispersion machine, for example, ball milling (for example: a ball mill, a vibration ball mill, a planetary ball mill, or a beads mill), sand milling, colloid milling, jet milling, roller milling, a vertical or horizontal agitator mill, an attritor, a colloid mill, a triple roll mill, a pearl mill, a super mill, an impeller, a disperser, a KD mill, dynatron, or a pressure kneader.

The dispersion method is preferably a method with a jet mill, more preferably a method with a wet jet mill.

The wet jet mill is a dispersion apparatus in which a mixture in a solvent serves as a high-speed flow and is pressure-fed through a nozzle placed in a sealed state in a pressure-resistant container. The wet jet mill allows the multi-walled carbon nanotube to be dispersed with collision between opposed flows, collision with a container wall, the disturbed flow and/or shear flow generated by the high-speed flow, and/or the like in the pressure-resistant container. The wet jet mill used here can be suitably an ultra-high-pressure homogenizer (model number: NAGS20, NAGS100, JAGS200, or NAGS1000) manufactured by Jokoh Co., Ltd. However, the wet jet mill is not limited thereto.

In a case where the above ultra-high-pressure homogenizer is used as the dispersion apparatus, the treatment pressure in dispersion is preferably 10 MPa to 250 MPa.

The method for producing the dispersion liquid may include a step of drying the multi-walled carbon nanotube powder being the conductive auxiliary agent according to the present disclosure (also referred to as "drying step"), before the above dispersion step.

If moisture is attached to the multi-walled carbon nanotube, the surface tension of water easily causes mutual attachment of such multi-walled carbon nanotubes and a reduction in dispersibility is feared. Accordingly, a drying step for a conductive auxiliary agent body can be performed before the dispersion step, thereby removing the moisture attached to the multi-walled carbon nanotube powder, inhibiting such multi-walled carbon nanotubes from being attached due to attachment of the moisture, and more enhancing dispersibility of the multi-walled carbon nanotube in the present disclosure, in the dispersion medium.

The drying method is not particularly limited.

Examples of the drying method include drying by heating, drying under vacuum, and drying by heating under vacuum.

The drying method is preferably drying by heating under vacuum.

The drying temperature is not particularly limited, and is, for example, preferably 40°C to 100°C.

The drying time is not particularly limited, and can be appropriately set depending on the drying temperature, the degree of attachment of moisture to the multi-walled carbon nanotube in the present disclosure, and the like.

Hereinafter, Production Examples of the dispersion liquid are shown, but production of the dispersion liquid according to the present disclosure is not limited to the following.

<Production Example 1: Production example of dispersion liquid>

The conductive auxiliary agent according to the present disclosure (for example, 0.040 g) is weighed and loaded into a three-necked flask. A large excess of ion-exchange water serving as the dispersion medium is injected (for example, 20 mL) to the flask into which the conductive auxiliary agent is loaded, and stirred at ordinary temperature (25°C, the same also applies to the following). Here, a known dispersant (for example, carboxymethylcellulose) may also be appropriately added. Next, a known dispersion apparatus (for example, an ultrasonic irradiation apparatus or a wet jet mill) is used to disperse the conductive auxiliary agent in the dispersion medium. The resulting dispersion liquid is further stirred by a stirrer at ordinary temperature for a long time (for example, 1 hour to 48 hours). The dispersion liquid according to the present disclosure is thus obtained.

The multi-walled CNT powder A or the multi-walled CNT powder B can also be formed into a dispersion liquid including the powder and a dispersion medium. The details of the component which can be included in the dispersion liquid and the method for producing the dispersion liquid may correspond to those in the descriptions of the dispersion liquid according to the present disclosure and the method for producing the dispersion liquid, in which the conductive auxiliary agent according to the present disclosure may be read as the multi-walled carbon nanotube powder (namely, multi-walled CNT powder A or multi-walled CNT powder B) of Aspect A or Aspect B.

The dispersion liquid according to the present disclosure may be a dispersion liquid including a multi-walled carbon nanotube having a tensile strength of 10 MPa to 100 MPa and a maximum length of 1000 $\mu$m to 30000 $\mu$m (Aspect C) and a dispersion medium. The details of the component which can be included in the dispersion liquid and the method for producing the dispersion liquid may correspond to those in the descriptions of the dispersion liquid according to the present disclosure and the method for producing the dispersion liquid, in which the conductive auxiliary agent according to the present disclosure may be read as the multi-walled carbon nanotube of Aspect C.

[Composition]

<Resin, ceramics, concrete, and the like>

The multi-walled CNT powder A or multi-walled CNT powder B can be a composition (hereinafter, called "the composition according to the present disclosure") including the powder and at least one selected from the group consisting of a resin, ceramics and concrete.

Examples of the resin include a thermoplastic resin and a thermosetting resin, preferably include an olefin-based resin, a polycarbonate-based resin, a polyester-based resin, a polyamide-based resin, a thermoplastic polyurethane resin, a polysulfone-based resin, and a silicone resin.

Examples of the ceramics include crystalline ceramics and non-crystalline ceramics.

Examples of the concrete include Portland cement concrete.

The composition according to the present disclosure may further include any other component such as water or an organic solvent.

When the content of the multi-walled CNT powder A or the multi-walled CNT powder B in the composition according to the present disclosure is 100 parts by mass, the content of at least one selected from the group consisting of a resin, ceramics and concrete is usually 10 to 1000000 parts by mass, preferably 100 to 100000 parts by mass, more preferably 1000 to 40000 parts by mass, and when such any other component is included, the content thereof is preferably 1 to 10000 parts by mass, more preferably 10 to 1000 parts by mass.

Each of the multi-walled CNT powder A, the multi-walled CNT powder B, the resin, the ceramics, the concrete, and such any other component in the composition according to the present disclosure may be included singly or in combinations of two or more kinds thereof.

<Method for producing composition>

The composition according to the present disclosure can be produced by, for example, kneading the multi-walled CNT powder A or the multi-walled CNT powder B with the resin, the ceramics, or the concrete before curing. The resin may be in the state of a powder, a pellet, or a solution or a dispersion liquid. The ceramics may be in the state of a powder, a precursor solution or a dispersion liquid.

The composition according to the present disclosure can also be produced by, for example, dispersing the multi-walled CNT powder A or the multi-walled CNT powder B in a solution of the resin, a ceramics precursor or a dispersion liquid, or the concrete before curing, and then performing molding.

<Application of composition>

The composition according to the present disclosure, when includes the resin or the ceramics, is useful as, for example, a structural material, a conductive material, a heat management material, or an antistatic material.

The composition according to the present disclosure, when includes the concrete, is useful as a building material enhanced in weight reduction and durability, or an electric storage device (if necessary, impregnated with an electrolyte).

[Electrode and secondary battery]

The electrode according to the present disclosure includes an electrode active material and the conductive auxiliary agent according to the present disclosure. The secondary battery according to the present disclosure includes the electrode according to the present disclosure.

The electrode according to the present disclosure includes the conductive auxiliary agent according to the present disclosure, and thus is excellent in formability of a conductive path in the electrode. Therefore, the secondary battery according to the present disclosure is excellent in cycle characteristics.

Hereinafter, one embodiment of the electrode and the secondary battery including the electrode is described.

<Electrode>

The electrode can include the conductive auxiliary agent according to the present disclosure. The conductive auxiliary agent included in the electrode is the same as the conductive auxiliary agent according to the present disclosure, and the description about the conductive auxiliary agent is omitted below.

The multi-walled CNT powder A or the multi-walled CNT powder B may be used as the conductive auxiliary agent (preferably, a conductive auxiliary agent for a negative electrode).

The electrode may be at least one of a positive electrode and a negative electrode.

The electrode may include an electrode active material layer. The electrode may include a current collector and an electrode active material layer placed on the current collector.

The current collector may be any one which does not induce any chemical change in the battery and which has conductivity, and is not particularly limited. For example, the current collector used here may be copper, stainless steel, aluminum, nickel, titanium, fired carbon, aluminum or stainless steel whose surface is treated with carbon, nickel, titanium, silver, or the like. Specifically, a transition metal adsorbing carbon well, such as copper or nickel, may be used in the current collector.

The electrode active material layer can include an electrode active material. The electrode active material is preferably an electrode active material particle.

In a case where the electrode is a positive electrode, the electrode active material particle is not particularly restricted, and can include a positive electrode active material usually used in an electrode material for a positive electrode. Specific examples of the positive electrode active material include layered compounds, and compounds substituted with one or more transition metals, such as lithium-cobalt oxide ($LiCoO_2$) and lithium-nickel oxide ($LiNiO_2$); lithium-iron oxide such as $LiFe_3O_4$; lithium-manganese oxide of chemical formula $Li_{1+c1}Mn_{2-c1}O_4$ ($0 \leq c1 \leq 0.33$), such as $LiMnO_3$, $LiMn_2O_3$, and $LiMnO_2$; lithium-copper oxide ($Li_2CuO_2$); vanadium oxide such as $LiV_3O_8$, $V_2O_5$, and $Cu_2V_2O_7$; Ni-site type lithium-nickel oxide represented by chemical formula $LiNi_{1-c2}M_{c2}O_2$ (wherein M is at least one selected from the group consisting of Co, Mn, Al, Cu, Fe, Mg, B, and Ga, and satisfies $0.01 \leq c2 \leq 0.66$); lithium-manganese composite oxide represented by chemical formula $LiMn_{2-c3}M_{c3}O_2$ (wherein M is at least one selected from the group consisting of Co, Ni, Fe, Cr, Zn, and Ta, and satisfies $0.01 \leq c3 \leq 0.1$) or $Li_2Mn_3MO_8$ (wherein M is at least one selected from the group consisting of Fe, Co, Ni, Cu, and Zn); and $LiMn_2O_4$ in which Li in such a chemical formula is partially substituted with an alkali earth metal ion.

In a case where the electrode is a negative electrode, the electrode active material is not particularly restricted, and can include a negative electrode active material usually used in an electrode material for a negative electrode. Specifically, the negative electrode active material can include a graphite-based active material particle or a silicon-based active material particle. The graphite-based active material particle used here may be one or more selected from the group consisting of artificial graphite, natural graphite, a graphitized carbon fiber, and graphitized mesocarbon microbeads. Artificial graphite can be used to improve rate characteristics.

The silicon-based active material particle used here may be one or more selected from the group consisting of Si, SiOx ($0 < x < 2$), a Si-C composite, and a Si-Y alloy (wherein Y is any element selected from the group consisting of alkali metals, alkali earth metals, transition metals, Group 13 elements, Group 14 elements, rare-earth elements, and combinations thereof). The silicon-based active material particle can be used to increase the capacity of the battery.

The electrode active material layer can further include a binder. The binder is not particularly restricted, and a binder usually used for electrode materials can be included. Examples of the binder include at least one polymer selected from the group consisting of a polyvinylidene fluoride-hexafluoropropylene copolymer (PVDF-co-HFP), polyvinylidenefluoride, polyacrylonitrile, polymethylmethacrylate, polyvinyl alcohol, carboxymethylcellulose (CMC), starch, hydroxypropylcellulose, regenerated cellulose, polyvinylpyrrolidone, tetrafluoroethylene, polyethylene, polypropylene, an ethylene-propylene-diene monomer (EPDM), sulfonated EPDM, styrene-butadiene rubber (SBR), fluororubber, and polyacrylic acid, and such a polymer in which a hydrogen atom in such a polymer is substituted with Li, Na, Ca, or the like.

<Secondary battery>

The secondary battery may be configured to include a negative electrode, a positive electrode, a separator interposed between the positive electrode and the negative electrode, and an electrolyte. At least one of the positive electrode and the negative electrode is the electrode according to the present disclosure, and the negative electrode is preferably the electrode according to the present disclosure.

The separator is not particularly limited as long as it is one which separates the negative electrode and the positive electrode to provide a movement passage of a lithium ion and which is usually used as a separator for secondary batteries. The separator is preferably low in resistance to ion movement of the electrolyte and excellent electrolytic solution retention capability. Specific examples of the separator include a porous polymer film. The porous polymer film may be, for example, a porous polymer film produced from a polyolefin-based polymer such as an ethylene homopolymer, a propylene homopolymer, an ethylene/butene copolymer, an ethylene/hexene copolymer, and an ethylene/methacrylate copolymer, or a stacked structure body in which two or more such films are stacked. The separator may also be a usual porous non-woven fabric, for example, a non-woven fabric including a high-melting-point glass fiber, a polyethylene terephthalate fiber, or the like. A separator with a ceramic component- or polymer substance-containing coating may also be adopted in order to ensure heat resistance or mechanical strength. The separator can selectively take a single-walled or multi-walled structure.

Examples of the electrolyte include an organic liquid electrolyte, an inorganic liquid electrolyte, a solid polymer electrolyte, a gel-type polymer electrolyte, a solid inorganic electrolyte, and a melt-type inorganic electrolyte each usable in production of a lithium ion secondary battery, but not limited thereto.

Specifically, the electrolyte can include a non-aqueous organic solvent and a metal salt.

Examples of the non-aqueous organic solvent include aprotic organic solvents such as N-methyl-2-pyrrolidinone, propylene carbonate, ethylene carbonate, butylene carbonate, dimethyl carbonate, diethyl carbonate, $\gamma$-butyrolactone, 1,2-dimethoxyethane, tetrahydroxyfuran, 2-methyltetrahydrofuran, dimethylsulfoxide, 1,3-dioxolane, formamide, dimethylformamide, dioxolane, acetonitrile, nitromethane, methyl formate, methyl acetate, phosphoric acid triester, trimethoxymethane, a dioxolane derivative, sulfolane, methylsulfolane, 1,3-dimethyl-2-imidazolidinone, a propylene carbonate derivative, a tetrahydrofuran derivative, ether, methyl propionate, and ethyl propionate.

Among carbonate-based organic solvents, each of ethylene carbonate and propylene carbonate being cyclic carbonates serves as a high-viscosity organic solvent to exhibit a high dielectric constant and dissociate a lithium salt, and thus can be preferably used as the non-aqueous organic solvent. The non-aqueous organic solvent is more preferably such a cyclic carbonate because a low-viscosity and low-dielectric constant, linear carbonate, such as dimethyl carbonate and diethyl carbonate, is mixed at an appropriate ratio and then used to obtain an electrolyte having a high electric conductivity.

The metal salt may be a lithium salt. The lithium salt is a substance to be easily dissolved in a non-aqueous electrolytic solution. Examples of the anion moiety in the lithium salt include one or more selected from the group consisting of $F^-$, $Cl^-$, $I^-$, $NO_3^-$, $N(CN)_2^-$, $BF_4^-$, $ClO_4^-$, $PF_6^-$, $(CF_3)_2PF_4^-$, $(CF_3)_3PF_3^-$, $(CF_3)_4PF_2^-$, $(CF_3)_5PF^-$, $(CF_3)_6P^-$, $CF_3SO_3^-$, $CF_3CF_2SO_3^-$, $(CF_3SO_2)_2N^-$, $(FSO_2)_2N^-$, $CF_3CF_2(CF_3)_2CO^-$, $(CF_3SO_2)_2CH^-$, $(SF_5)_3C^-$, $(CF_3SO_2)_3C^-$, $CF_3(CF_2)_7SO_3^-$, $CF_3CO_2^-$, $CH_3CO_2^-$, $SCN^-$, and $(CF_3CF_2SO_2)_2N^-$.

The electrolyte may further include, in addition to constituent components of the electrolyte, the non-aqueous organic solvent and the metal salt, a haloalkylene carbonate-based compound such as difluoroethylene carbonate, and/or one or more additives such as pyridine, triethyl phosphite, triethanolamine, cyclic ether, ethylenediamine, n-glyme (glyme), hexaphosphoric triamide, a nitrobenzene derivative, sulfur, a quinonimine dye, N-substituted oxazolidinone, N,N-substituted imidazolidine, ethylene glycol dialkyl ether, an ammonium salt, pyrrole, 2-methoxyethanol, or aluminum trichloride, for the purposes of enhancements in battery lifetime characteristics, suppression of a reduction in battery capacity, an enhancement in battery discharge capacity, and the like.

The above secondary battery can be formed into a battery module including the secondary battery as a unit cell and a battery pack including the battery module. The battery module and the battery pack can be each used in a power source for a medium to large sized device selected from the group consisting of an electric vehicle, a hybrid electric vehicle, a plug-in hybrid electric vehicle, and a power storage system.

Hereinafter, Production Examples of the electrode and the secondary battery are shown, but production of the electrode and the secondary battery according to the present disclosure is not limited to the following.

<Production Example 2: Production example of electrode (negative electrode) and secondary battery>

A slurry for a negative electrode is produced by mixing known artificial graphite being a negative electrode active material, the dispersion liquid according to the present disclosure and known carbon black being each a conductive auxiliary agent for a negative electrode, and known styrene-butadiene rubber (SBR) and known carboxymethylcellulose (CMC) being each a binder for a negative electrode, at a predetermined mass ratio, with distilled water.

The slurry for a negative electrode is applied to a negative electrode current collector (Cu), dried, and rolled to regulate the final thickness (namely, the total thickness of the current collector and the negative electrode active material layer), thereby producing a negative electrode.

Thereafter, the current collector on which the slurry for a negative electrode is applied is further dried in an oven, thereby producing a negative electrode.

Next, a known slurry for a positive electrode is applied to a positive electrode current collector (Al), dried, and rolled to regulate the final thickness (namely, the total thickness of the current collector and the positive electrode active material layer), thereby producing a positive electrode. The slurry for a positive electrode, used here, can be, for example, a positive electrode slurry described in paragraph [0096] of Japanese Translation of PCT International Application Publication No. 2022-521422.

The separator is interposed between the negative electrode and the positive electrode to produce a monocell, and an electrolytic solution is injected to produce a lithium ion secondary battery.

Cycle characteristics of the lithium ion secondary battery can be evaluated with the capacity maintenance rate.

Specifically, the lithium ion secondary battery is subjected to lifetime evaluation at 45°C with a charge C-rate (Rate) fixed to 1.0 C and a discharge C-rate (Rate) fixed to 1.0 C, and the capacity maintenance rate (%) for 100 cycles is evaluated.

When the conductive auxiliary agent according to the present disclosure is used, a conductive path is preferably constructed in an electrode and thus cycle characteristics are excellent.

The planar assembly according to the present disclosure includes the multi-walled carbon nanotube powder according to the present disclosure. The proportion of the multi-walled carbon nanotube powder according to the present disclosure included in the planar assembly according to the present disclosure is usually 1% by mass or more based on the total mass of the planar assembly. The planar assembly according to the present disclosure may include any other component such as a carbon nanotube powder having a maximum length of less than 1000 μm (in particular, multi-walled carbon nanotube powder).

[Method for producing planar assembly]

The method for producing the planar assembly according to the present disclosure is not particularly limited.
The planar assembly according to the present disclosure can be produced as, for example, a non-woven fabric-like planar assembly by dispersing the multi-walled carbon nanotube powder according to the present disclosure or the multi-walled carbon nanotube powder according to the present disclosure and any other component such as a carbon nanotube powder having a maximum length of less than 1000 μm (in particular, multi-walled carbon nanotube powder) in water or any other fluid and performing filtration once or two or more times.
Examples of a certain embodiment of the planar assembly according to the present disclosure include a film.
The planar assembly according to the present disclosure is useful for, for example, a filter, an electromagnetic wave shielding, and a pellicle for extreme ultraviolet rays (EUV: Extreme ultraviolet).

Examples

Hereinafter, the conductive auxiliary agent according to the present disclosure is further specifically described with reference to Examples. The conductive auxiliary agent according to the present disclosure is not limited to the following Examples without departing from the gist thereof.

(Example 1)

1. Preparation of MWCNT 1

As MWCNT 1, "multi-walled carbon nanotube" (Catalog No.: 901019, 50-90 nm diameter, >95% carbon basis, manufactured by Sigma-Aldrich) was prepared.

2-1. Preparation of dispersion liquid 1

The following materials were mixed, and treated with Ace Homogenizer manufactured by Nippon Seiki Co., Ltd., to carry out pre-dispersion, thereby obtaining pre-dispersion liquid 1.

(Compositional ratio of dispersion liquid)

| | | |
|---|---|---|
| · | MWCNT 1 obtained above | 1.1 g |
| · | CARBOXYMETHYL CELLULOSE SODIUM SALT HIGH VISCOSITY (manufactured by MP Biomedicals) | 1.65 g |
| · | Pure water | 547.2 g |

An ultra-high-pressure homogenizer (model number: NAGS100) manufactured by Jokoh Co., Ltd. was used as a wet jet mill to carry out main dispersion of pre-dispersion liquid 1, thereby obtaining dispersion liquid 1.
Nozzle diameter: 0.22 mm

Pressure: 85 MPa
Number of times: 8
System: circulation system

2-2. Tensile strength

One obtained by pouring dispersion liquid 1 on a glass slide silicon plate of 22 mm × 75 mm × 3 mm (#08-1044 manufactured by Dosaka EM Co., Ltd.) and performing heating to 100°C and drying was adopted as a measurement sample, and fixed to a grasping portion of a tensile tester (Autograph AG-IS manufactured by Shimadzu Corporation), to perform a tensile test at a rate of 1 mm/minute.

As a result, the tensile strength was 11.5 MPa.

3. Maximum length

One-hundred MWCNTs were focused on and observed in plural mutually-adjacent SEM photographs (magnification: 5000x) of MWCNT 1, and thus the maximum value of the maximum length was 50 $\mu$m.

4. Production of MWCNT powder 1

MWCNT powder 1 was obtained by grinding MWCNT 1 with a refrigeration grinder (JFC-2000 manufactured by Japan Analytical Industry). Five g of MWCNT 1 was placed in a 75-ml sample container, furthermore one steel ball made of tungsten carbide was placed in the sample container, and thereafter the sample container was equipped with a grinding rod. The entire sample container was immersed in liquid nitrogen to cool MWCNT 1 and the steel ball, and thereafter the grinding rod was reciprocated up and down to move the steel ball in the sample container, thereby grinding MWCNT 1.

Retention time of freezing: 5 minutes
Grinding time: 2 minutes

5. Measurement of angle of repose

The angle of repose of MWCNT powder 1 was measured by the above-mentioned injection method. A sufficient amount of MWCNT powder 1 was deposited on a measurement stage having a disc-like upper surface, and the angle between the powder deposited in a conical manner and the horizontal surface was measured with a protractor.

As a result, the angle of repose was 35 degrees.

6. Measurement of volume resistivity

The volume resistivity ($\Omega \cdot$cm) was measured with a Loresta apparatus (product name: powder resistance measurement system MCP-PD51, low-resistivity meter Loresta-GP, and low-resistance probe for powders, MCP-PD511 (constant-current application-type four probe method), all manufactured by Nittoseiko Analytech Co., Ltd.) after MWCNT powder 1 was introduced into a powder resistivity measurement probe unit and pressed at 20 kN with an attached hydraulic pump to allow a target load to be achieved.

As a result, the volume resistivity at 20 kN was $9.2 \times 10^{-3}$ $\Omega \cdot$cm.

(Example 2)

1. Preparation of ULMWCNT-containing MWCNT 2

ULMWCNT-containing MWCNT 2 was produced by a floating catalyst method (CVD method) with direct interaction with a self-collected CNT bundle in a gas phase.

First, ferrocene as a Fe atom-containing metal catalyst precursor and thiophene as a promotor were introduced into a continuous flow of a carrier gas in a reflux reactor temperature-controlled to 400°C to 700°C. The carrier gas used here was a mixed gas of nitrogen and argon. The flow rate of the carrier gas was set to 30000 sccm (standard cubic centimeter per minute).

The temperature in the reflux reactor was kept in the above range, thereby allowing the metal catalyst precursor to be produced as a particulate metal catalyst. The region in which the metal catalyst is produced is referred to as "first temperature zone".

Next, methane as a carbon source was released into a carrier gas flow. The metal catalyst and the carbon source were fed to a second temperature zone located downstream of the first temperature zone and temperature-controlled to 1400°C. The second temperature zone is kept at a sufficient temperature for producing a carbon nanotube aggregate.

In the second temperature zone, the electric field was generated in a temperature-controlled flow reactor and thus an aggregate of ULMWCNT-containing MWCNT was produced.

The aggregate was ejected as the aggregate of ULMWCNT-containing MWCNT in the form of continuous ejection via a discharge port of a flow-type reactor temperature-controlled to 100°C to 500°C, and subjected to continuous discharge to collect ULMWCNT-containing sheet-like MWCNT.

The resulting ULMWCNT-containing sheet-like MWCNT includes ULMWCNT and MWCNT.

The resulting ULMWCNT-containing sheet-like MWCNT was washed with deionized water for 10 seconds, thereby obtaining ULMWCNT-containing MWCNT 2.

2. Tensile strength

One obtained by cutting ULMWCNT-containing MWCNT 2 of Example 2 to a size of 5 mm × 100 mm was adopted as a measurement sample, and fixed to a grasping portion of a tensile tester (Autograph AG-IS manufactured by Shimadzu Corporation), to perform a tensile test at a rate of 1 mm/minute.

As a result, the tensile strength was 11.3 MPa.

3. Maximum length

ULMWCNT-containing MWCNT 2 was used to measure the maximum length in the same manner as in Example 1, and as a result, the maximum value of the maximum length was 3500 $\mu$m.

4. Production of ULMWCNT-containing MWCNT powder 2

ULMWCNT-containing MWCNT powder 2 was obtained in the same manner as in Example 1 except that ULMWCNT-containing MWCNT 2 was used and the grinding time was changed.
Grinding time: 7 minutes

5. Measurement of angle of repose

ULMWCNT-containing MWCNT powder 2 was used to measure the angle of repose in the same manner as in Example 1, and as a result, the angle of repose was 60 degrees.

6. Measurement of volume resistivity

ULMWCNT-containing MWCNT powder 2 was used to measure the volume resistivity in the same manner as in Example 1, and as a result, the volume resistivity at 20 kN was $5.0 \times 10^{-3}$ $\Omega \cdot$cm.

(Example 3)

1. Production of ULMWCNT-containing MWCNT powder 3

ULMWCNT-containing MWCNT powder 3 was obtained in the same manner as in Example 1 except that ULMWCNT-containing MWCNT 2 was used and the grinding time was changed.
Grinding time: 10 minutes

2. Measurement of angle of repose

ULMWCNT-containing MWCNT powder 3 was used to measure the angle of repose in the same manner as in Example 1, and as a result, the angle of repose was 45 degrees.

3. Measurement of volume resistivity

ULMWCNT-containing MWCNT powder 3 was used to measure the volume resistivity in the same manner as in Example 1, and as a result, the volume resistivity at 20 kN was $5.2 \times 10^{-3}$ $\Omega \cdot$cm.

(Comparative Example 1)

1. Preparation of MWCNT 4

As MWCNT 4, "multi-walled carbon nanotube" (Catalog No.: FT7000, manufactured by Jiangsu Cnano Technology Ltd.) was prepared.

2-1. Preparation of dispersion liquid 4

MWCNT 4 was used to obtain dispersion liquid 4 in the same manner as in Example 1.

2-2. Tensile strength

Dispersion liquid 4 was used to measure the tensile strength in the same manner as in Example 1, and as a result, the tensile strength was 6.9 MPa.

3. Maximum length

MWCNT 4 was used to measure the maximum length in the same manner as in Example 1, and as a result, the maximum value of the maximum length was 20 $\mu$m.

4. Production of MWCNT powder 4

MWCNT 4 was used to obtain MWCNT powder 4 in the same manner as in Example 1.

5. Measurement of angle of repose

MWCNT powder 4 was used to measure the angle of repose in the same manner as in Example 1, and as a result, the angle of repose was 60 degrees.

6. Measurement of volume resistivity

MWCNT powder 4 was used to measure the volume resistivity in the same manner as in Example 1, and as a result, the volume resistivity at 20 kN was $2.2 \times 10^{-2}$ $\Omega$·cm.

(Comparative Example 2)

1. Preparation of MWCNT 5

As MWCNT 5, "multi-walled carbon nanotube" (Catalog No.: FT9100, manufactured by Jiangsu Cnano Technology Ltd.) was prepared.

2-1. Preparation of dispersion liquid 5

MWCNT 5 was used to obtain dispersion liquid 5 in the same manner as in Example 1.

2-2. Tensile strength

Dispersion liquid 5 was used to measure the tensile strength in the same manner as in Example 1, and as a result, the tensile strength was 2.3 MPa.

3. Maximum length

MWCNT 5 was used to measure the maximum length in the same manner as in Example 1, and as a result, the maximum value of the maximum length was 15 $\mu$m.

4. Production of MWCNT powder 5

MWCNT 5 was used to obtain MWCNT powder 5 in the same manner as in Example 1.

5. Measurement of angle of repose

MWCNT powder 5 was used to measure the angle of repose in the same manner as in Example 1, and as a result, the angle of repose was 60 degrees.

6. Measurement of volume resistivity

MWCNT powder 5 was used to measure the volume resistivity in the same manner as in Example 1, and as a result, the volume resistivity at 20 kN was $1.7 \times 10^{-2}$ $\Omega\cdot$cm.

(Comparative Example 3)

1. Preparation of MWCNT 6

As MWCNT 6, "multi-walled carbon nanotube" (Catalog No.: FT6120, manufactured by Jiangsu Cnano Technology Ltd.) was prepared.

2-1. Preparation of dispersion liquid 6

MWCNT 6 was used to obtain dispersion liquid 6 in the same manner as in Example 1.

2-2. Tensile strength

Dispersion liquid 6 was used to measure the tensile strength in the same manner as in Example 1, and as a result, the tensile strength was 8.2 MPa.

3. Maximum length

MWCNT 6 was used to measure the maximum length in the same manner as in Example 1, and as a result, the maximum value of the maximum length was 250 $\mu$m.

4. Production of MWCNT powder 6

MWCNT 6 was used to obtain MWCNT powder 6 in the same manner as in Example 1.

5. Measurement of angle of repose

MWCNT powder 6 was used to measure the angle of repose in the same manner as in Example 1, and as a result, the angle of repose was 55 degrees.

6. Measurement of volume resistivity

MWCNT powder 6 was used to measure the volume resistivity in the same manner as in Example 1, and as a result, the volume resistivity at 20 kN was $1.5 \times 10^{-2}$ $\Omega\cdot$cm.
The above results are shown in Table 1.

[Table 1]

|  | MWCNT | | MWCNT powder | |
| --- | --- | --- | --- | --- |
|  | Tensile strength (MPa) | Maximum value ($\mu$m) of maximum length | Angle of repose (degrees) | Volume resistivity ($\Omega\cdot$cm) |
| Example 1 | 11.5 | 50 | 35 | $9.2\times10^{-3}$ |
| Example 2 | 11.3 | 3500 | 60 | $5.0\times10^{-3}$ |
| Example 3 | 11.3 | 3500 | 45 | $5.2\times10^{-3}$ |
| Comparative Example 1 | 6.9 | 20 | 60 | $2.2\times10^{-2}$ |
| Comparative Example 2 | 2.3 | 15 | 60 | $1.7\times10^{-2}$ |
| Comparative Example 3 | 8.2 | 250 | 55 | $1.5\times10^{-2}$ |

The multi-walled carbon nanotube powder obtained in each of Examples 1 to 3 was confirmed to be a ground product of a multi-walled carbon nanotube having a tensile strength of 10 MPa to 100 MPa and have an angle of repose of 10 degrees to 90 degrees. The multi-walled carbon nanotube powder obtained in each of Examples 1 to 3 has a volume resistivity of $5.0 \times 10^{-3}$ $\Omega \cdot$cm to $9.2 \times 10^{-3}$ $\Omega \cdot$cm, namely, $5.0 \times 10^{-2}$ $\Omega \cdot$cm or less, and thus is a conductive auxiliary agent excellent in the enhancement effect of conductivity.

**Claims**

1. A conductive auxiliary agent, comprising a multi-walled carbon nanotube powder that is a ground product of a multi-walled carbon nanotube having a tensile strength of 10 MPa to 100 MPa and that has an angle of repose of 10 degrees to 90 degrees.

2. The conductive auxiliary agent according to claim 1, wherein the multi-walled carbon nanotube has a maximum length of 10 $\mu$m to 30000 $\mu$m.

3. The conductive auxiliary agent according to claim 1 or claim 2, which is a conductive auxiliary agent for a negative electrode.

4. A dispersion liquid comprising the conductive auxiliary agent according to claim 1 or claim 2 and a dispersion medium.

5. An electrode comprising an electrode active material and the conductive auxiliary agent according to claim 1 or claim 2.

6. A secondary battery comprising the electrode according to claim 5.

7. A multi-walled carbon nanotube powder that is a ground product of a multi-walled carbon nanotube having a tensile strength of 10 MPa to 100 MPa and a maximum length of 1000 $\mu$m to 30000 $\mu$m and that has an angle of repose of 10 degrees to 90 degrees.

8. The multi-walled carbon nanotube powder according to claim 7, which is a conductive auxiliary agent for a negative electrode.

9. A dispersion liquid comprising the multi-walled carbon nanotube powder according to claim 7 or claim 8 and a dispersion medium.

10. A composition comprising the multi-walled carbon nanotube powder according to claim 7 or claim 8 and at least one selected from the group consisting of a resin, ceramics and concrete.

11. An electrode comprising an electrode active material and the multi-walled carbon nanotube powder according to claim 7 or claim 8.

12. A secondary battery comprising the electrode according to claim 11.

13. A dispersion liquid comprising a multi-walled carbon nanotube having a tensile strength of 10 MPa to 100 MPa and a maximum length of 1000 $\mu$m to 30000 $\mu$m, and a dispersion medium.

14. A planar assembly comprising the multi-walled carbon nanotube powder according to claim 7.

15. A filter comprising the planar assembly according to claim 14.

16. An electromagnetic wave shielding comprising the planar assembly according to claim 14.

17. A pellicle for extreme ultraviolet rays comprising the planar assembly according to claim 14.

Figure 1

## INTERNATIONAL SEARCH REPORT

| International application No. |
|---|
| **PCT/JP2024/021494** |

**A. CLASSIFICATION OF SUBJECT MATTER**

*H01M 4/62*(2006.01)i; *C01B 32/16*(2017.01)i; *C01B 32/168*(2017.01)i; *G03F 1/62*(2012.01)i; *H01B 1/04*(2006.01)i;
*H01M 4/13*(2010.01)i; *H01M 4/139*(2010.01)i; *H05K 9/00*(2006.01)i
FI: H01M4/62 Z; C01B32/16; G03F1/62; H01B1/04; H01M4/13; H01M4/139; H05K9/00 W; C01B32/168

According to International Patent Classification (IPC) or to both national classification and IPC

**B. FIELDS SEARCHED**

Minimum documentation searched (classification system followed by classification symbols)

H01M4/62; C01B32/16; C01B32/168; G03F1/62; H01B1/04; H01M4/13; H01M4/139; H05K9/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2021-95314 A (TOYO INK SC HOLDINGS CO., LTD.) 24 June 2021 (2021-06-24) paragraph [0001], examples 1, 27 | 1-12, 14 |
| Y | | 10, 14-17 |
| A | | 13 |
| Y | JP 2020-45256 A (KATANO SENKAKU KK) 26 March 2020 (2020-03-26) paragraph [0002] | 10 |
| Y | JP 2017-51384 A (PROT CO., LTD.) 16 March 2017 (2017-03-16) paragraph [0002] | 14-15 |
| Y | JP 2009-277736 A (HOKKAIDO UNIV) 26 November 2009 (2009-11-26) paragraphs [0008], [0014], [0030] | 14, 16 |
| Y | JP 2020-160345 A (MITSUI CHEMICALS, INC.) 01 October 2020 (2020-10-01) paragraphs [0005], [0009], [0015] | 14, 17 |

✓ Further documents are listed in the continuation of Box C.  ✓ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **08 July 2024** | **10 September 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**

International application No.

**PCT/JP2024/021494**

**C.    DOCUMENTS CONSIDERED TO BE RELEVANT**

| Category* | Citation of document, with indication, where appropriate, of the relevant passages | Relevant to claim No. |
|---|---|---|
| A | JP 8-231210 A (NEC CORPORATION) 10 September 1996 (1996-09-10)<br>      entire text | 1-17 |

Form PCT/ISA/210 (second sheet) (July 2022)

**INTERNATIONAL SEARCH REPORT**
Information on patent family members

International application No.

**PCT/JP2024/021494**

| Patent document cited in search report | | | Publication date (day/month/year) | Patent family member(s) | Publication date (day/month/year) |
|---|---|---|---|---|---|
| JP | 2021-95314 | A | 24 June 2021 | (Family: none) | |
| JP | 2020-45256 | A | 26 March 2020 | (Family: none) | |
| JP | 2017-51384 | A | 16 March 2017 | (Family: none) | |
| JP | 2009-277736 | A | 26 November 2009 | (Family: none) | |
| JP | 2020-160345 | A | 01 October 2020 | (Family: none) | |
| JP | 8-231210 | A | 10 September 1996 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021095314 A
- JP 2016102047 A
- JP 2022521422 W